# DEMANDE DE BREVET EUROPEEN

(11) **EP 4 322 220 A1**
(43) Date de publication de la demande: **14.02.2024**
(21) Numéro de dépôt: 23188271.3
(22) Date de dépôt: 28.07.2023
(51) Int. Cl.: H01L 27/146

(54) **CAPTEUR D'IMAGES POLARIMETRIQUE**

(30) Priorité: 09.08.2022 FR 2208214
(71) Demandeur: Commissariat à l'énergie atomique et aux énergies alternatives, 75015 Paris (FR)
(72) Inventeur: VAILLANT, Jérôme, 38054 GRENOBLE CEDEX 09 (FR); DENEUVILLE, François, 38054 GRENOBLE CEDEX 09 (FR); CROCHERIE, Axel, 38000 GRENOBLE (FR); OSTROVSKY, Alain, 38000 GRENOBLE (FR)
(74) Mandataire: Cabinet Beaumont

(57) **Abrégé**

La présente description concerne un capteur d'images polarimétrique (100) formé dans et sur un substrat semiconducteur (101), le capteur comprenant une pluralité de pixels (P) comprenant chacun :
- une région photosensible (103) formée dans le substrat semiconducteur (101) ;
- une structure de diffraction (119) formée du côté d'une face d'éclairement de la région photosensible (103) ; et
- une structure de polarisation (111) formée du côté de la structure de diffraction (119) opposé à la région photosensible (103) .

## Description

### Domaine technique

La présente description concerne de façon générale les capteurs d'images, et vise plus particulièrement des capteurs d'images dits polarimétriques, adaptés à enregistrer des informations relatives à la polarisation de la lumière captée.

### Technique antérieure

La mesure de l'information de polarisation de la lumière lors de l'acquisition d'une image peut présenter un intérêt pour de nombreuses applications. Elle permet en particulier la mise en oeuvre de traitements d'amélioration des images, adaptés en fonction de l'application considérée. Par exemple, elle permet de réduire ou au contraire d'exacerber des reflets sur une image d'une surface comme une vitre ou de l'eau. Elle rend en outre possible de détecter des objets manufacturés dans un environnement naturel (détection de camouflage ou applications de déminage par exemple), ces derniers présentant généralement une signature en polarisation. Parmi les applications pouvant tirer profit de la mesure de l'information de polarisation, on peut également citer des applications de contrôle industriel, des applications biomédicales, par exemple des applications de détection de cellules cancéreuses (ces dernières polarisant la lumière de par leur nature fibreuse), des applications d'amélioration de contraste pour la capture d'images en milieu diffusant (brouillard, imagerie sous-marine, etc.), ou encore des applications de cartographie de distance ou acquisition d'images de profondeur, dans lesquelles la polarisation peut fournir des informations sur l'orientation de la surface des objets manufacturés, et ainsi aider la reconstruction 3D en complément d'une autre modalité comme l'illumination active par lumière structurée ou par mesure de temps de vol.

Pour mesurer l'information de polarisation, il a déjà été proposé d'acquérir successivement, au moyen d'un même capteur, plusieurs images d'une même scène, en plaçant à chaque acquisition un polariseur en vis à vis du capteur, et en changeant de polariseur entre deux acquisitions successives. Il en résulte des systèmes d'acquisition relativement volumineux, avec la présence devant le capteur d'un mécanisme, par exemple une roue ou platine rotative motorisée sur laquelle sont fixés les différents polariseurs, permettant de changer le polariseur entre deux acquisitions. Une autre limitation est liée à la nécessité d'acquérir successivement plusieurs images de la scène pour enregistrer plusieurs états de polarisation. Ceci peut notamment poser problème lorsque la scène varie dans le temps.

Pour palier ces limitations, il a été proposé de placer une matrice de filtres polariseurs en vis à vis du capteur d'images. Une limitation reste toutefois que les filtres polariseurs bloquent une partie du signal lumineux reçu par le système d'acquisition. Ainsi, la sensibilité globale ou rendement quantique global du système d'acquisition est relativement faible.

Il serait souhaitable de palier au moins en partie certaines limitations des solutions connues d'acquisition d'images polarimétriques.

### Résumé de l'invention

Pour cela, un mode de réalisation prévoit un capteur d'images polarimétrique formé dans et sur un substrat semiconducteur, le capteur comprenant une pluralité de pixels comprenant chacun :
- une région photosensible formée dans le substrat semiconducteur ;
- une structure de diffraction formée du côté d'une face d'éclairement de la région photosensible ; et
- une structure de polarisation formée du côté de la structure de diffraction opposé à la région photosensible.

Selon un mode de réalisation, la pluralité de pixels comprend au moins des premier et deuxième pixels adaptés à mesurer des rayonnements selon respectivement des première et deuxième polarisations distinctes, dans lequel :
la structure de polarisation du premier pixel est adaptée à transmettre majoritairement des rayonnements selon la première polarisation et la structure de polarisation du deuxième pixel est adaptée à transmettre majoritairement des rayonnements selon la deuxième polarisation ; et
la structure de diffraction du premier pixel est adaptée à favoriser l'absorption, dans la région photosensible du pixel, des rayonnements selon la première polarisation par rapport aux rayonnements selon la deuxième polarisation, et la structure de diffraction du deuxième pixel est adaptée à favoriser l'absorption, dans la région photosensible du pixel, des rayonnements selon la deuxième polarisation par rapport aux rayonnements selon la première polarisation.

Selon un mode de réalisation, dans chaque pixel, la structure de polarisation du pixel comprend une pluralité de barres parallèles.

Selon un mode de réalisation, les barres parallèles sont métalliques.

Selon un mode de réalisation, dans chaque pixel, la structure de diffraction du pixel comprend une pluralité de cavités ou tranchées s'étendant verticalement dans le substrat du côté de la face d'éclairement de la région photosensible.

Selon un mode de réalisation, les cavités ou tranchées s'étendent sur une profondeur comprise entre 50 et 500 nm.

Selon un mode de réalisation, la pluralité de pixels comprend différents pixels adaptés à mesurer des rayonnements dans des gammes de longueurs d'ondes différentes, et, dans chaque pixel, la structure de polarisation et/ou la structure de diffraction sont adaptées en fonction de la gamme de longueurs d'onde destinée à être mesurée par le pixel.

Selon un mode de réalisation, dans chaque pixel, la structure de polarisation et/ou la structure de diffraction sont adaptées en fonction de l'angle d'incidence des rayonnements reçus par le pixel.

Selon un mode de réalisation, le capteur comprend un empilement d'interconnexion recouvrant une face du substrat opposée aux structures de diffraction et aux structures de polarisation.

Selon un mode de réalisation, les structures de polarisation sont des filtres polariseurs.

Selon un mode de réalisation, les structures de polarisation sont des routeurs de polarisation.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe partielle et schématique d'un exemple d'un capteur d'images polarimétrique selon un mode de réalisation ;
la figure 2 est une vue de dessus schématique d'un exemple de réalisation de structures de polarisation du capteur de la figure 1 ;
la figure 3 est une vue de dessus schématique d'un exemple de réalisation de structures de diffraction du capteur de la figure 1 ; et
la figure 4A, la figure 4B, la figure 4C, la figure 4D, la figure 4E, la figure 4F, la figure 4G, la figure 4H et la figure 4I sont des vues en coupe illustrant des étapes successives d'un exemple d'un procédé de réalisation du capteur de la figure 1.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les éléments de photo-détection et les circuits électroniques de contrôle des capteurs d'images décrits n'ont pas été détaillés, les modes de réalisation décrits étant compatibles avec les réalisations usuelles de ces éléments. En outre, les applications que peuvent avoir les capteurs d'images décrits n'ont pas été détaillées, les modes de réalisation décrits étant compatibles avec toutes ou la plupart des applications connues des systèmes d'acquisition d'images polarimétriques.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

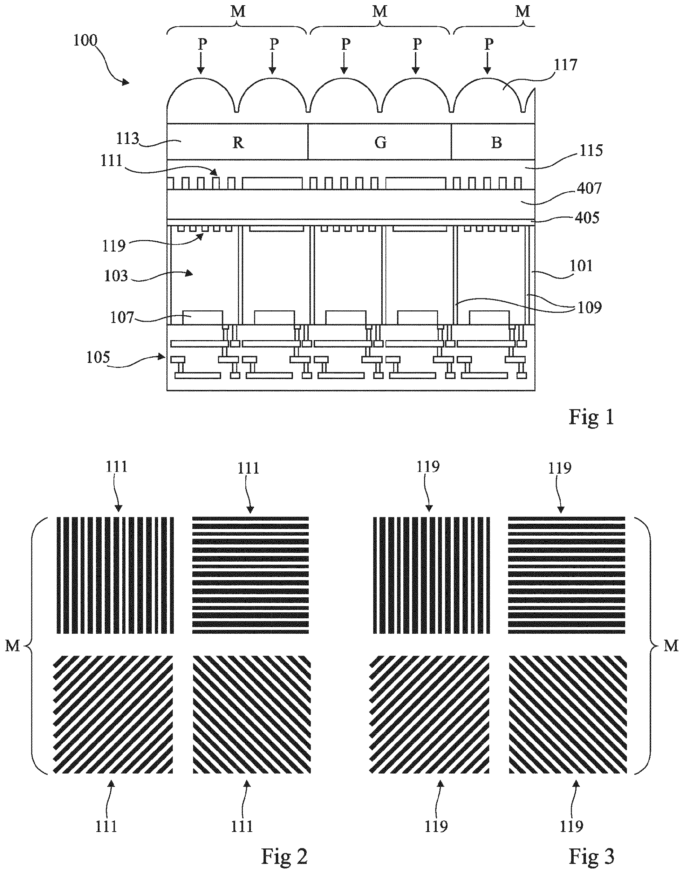

La figure 1 est une vue en coupe partielle et schématique d'un exemple d'un capteur d'images polarimétrique 100 selon un mode de réalisation.

Le capteur 100 est formé dans et sur un substrat semiconducteur 101. Le substrat 101 est par exemple en un matériau semiconducteur monocristallin. Le substrat 101 est par exemple en silicium, par exemple en silicium monocristallin.

Le capteur 100 comprend une pluralité de pixels P formés dans et sur le substrat semiconducteur 101. En vue de dessus, les pixels P sont par exemple agencés en matrice selon des rangées et des colonnes.

Le capteur 100 comprend en outre, du côté d'une première face du substrat 101, appelée face avant, correspondant à la face inférieure du substrat 101 dans l'orientation de la figure, un empilement 105 de couches isolantes et conductrices (par exemple métalliques), appelé empilement d'interconnexion, dans lequel sont formés des éléments d'interconnexion (par exemple des pistes et vias conducteurs d'interconnexion) des pixels du capteur.

Dans l'exemple de la figure 1, le capteur 100 est un capteur à éclairement par la face arrière, aussi appelé capteur BSI (de l'anglais « Backside Illumination Sensor »), c'est à dire que les rayons lumineux en provenance de la scène à imager éclairent le substrat par sa face arrière, c'est à dire sa face opposée à l'empilement d'interconnexion 105, à savoir sa face supérieure dans l'orientation de la figure 1.

Chaque pixel P du capteur 100 comprend une région photosensible 103 formée dans le substrat 101. Chaque région photosensible 103 comprend par exemple un élément de photo-détection 107, par exemple une photodiode. Dans l'exemple représenté, les régions photosensibles 103 des pixels P sont séparées latéralement les unes des autres par des murs d'isolation 109. Les murs d'isolation 109 sont par exemple en un matériau diélectrique, par exemple de l'oxyde de silicium. A titre de variante (non détaillée sur les figures), les murs d'isolation 109 comprennent des parois latérales externes en un matériau diélectrique, par exemple de l'oxyde de silicium, et une paroi centrale en un matériau électriquement conducteur, par exemple du silicium polycristallin dopé ou un métal. Dans cet exemple, les murs d'isolation 109 s'étendent verticalement à travers toute l'épaisseur du substrat 101. L'épaisseur du substrat 101 est par exemple comprise entre 1 et 20 µm, par exemple entre 3 et 10 µm. A titre de variante, les murs d'isolation 109 peuvent être omis.

Chaque pixel P comprend une structure de polarisation 111, par exemple un filtre polariseur, disposé en vis à vis de la région photosensible 103 du pixel, du côté de la face d'éclairement de la région photosensible 103, c'est à dire du côté de la face supérieure du substrat 101 dans l'orientation de la figure 1.

Chaque structure de polarisation 111 est adapté à transmettre majoritairement des rayonnements lumineux selon une polarisation prédéfinie.

Dans l'exemple de la figure 1, le capteur comprend plusieurs pixels P dont les structures de polarisation 111 respectives présentent des orientations de polarisation différentes et sont ainsi adaptées à transmettre majoritairement des rayons lumineux selon des polarisations différentes. Ceci permet de mesurer, au moyen de pixels P distincts, des intensités de rayonnements lumineux reçus selon des polarisations différentes. Autrement dit, le capteur comprend au moins des premier et deuxième pixels P destinés à mesurer des intensités de rayonnements lumineux reçus selon respectivement des première et deuxième polarisations, par exemple des première et deuxième polarisations linéaires orthogonales. A titre d'exemple, la structure de polarisation 111 du premier pixel présente un coefficient de transmission des rayonnements selon la première polarisation supérieur à son coefficient de transmission des rayonnements selon la deuxième polarisation, et la structure de polarisation 111 du deuxième pixel présente un coefficient de transmission des rayonnements selon la deuxième polarisation supérieur à son coefficient de transmission des rayonnements selon la première polarisation.

Les structures de polarisations sont par exemple des structures métalliques comprenant des ouvertures et transmettant majoritairement les rayonnements selon une polarisation prédéfinie, et absorbant ou réfléchissant les rayonnements selon les autres polarisations. Les structures métalliques sont par exemple en aluminium ou en cuivre. A titre de variante, d'autres métaux peuvent être utilisés, par exemple l'argent, l'or, le tungstène ou le titane.

A titre d'exemple, un matériau de remplissage 115, par exemple un matériau diélectrique, par exemple de l'oxyde de silicium, du nitrure de silicium, de l'alumine (Al₂O₃), de l'oxyde de tantale ou de l'oxyde d'hafnium, remplit les ouvertures formées dans les structures métalliques. Dans cet exemple, le matériau 115 recouvre en outre les structures de polarisation 111, formant une couche de planarisation 115. A titre de variante, les ouvertures des structures de polarisation 111 peuvent être laissées vides ou remplies d'air.

En pratique, le choix des motifs et le dimensionnement des structures de polarisation 111 peut être réalisé au moyen d'outils connus de simulation électromagnétiques.

A titre d'exemple, les pixels P sont répartis en macropixels M comprenant chacun au moins deux pixels P adjacents. Dans chaque macropixel M, les pixels P du macropixel ont des structures de polarisation 111 différentes. Ainsi, dans chaque macropixel M, les pixels P du macropixel mesurent des intensités de rayonnement lumineux reçus selon des polarisations différentes.

La figure 2 illustre schématiquement les structures de polarisation 111 des pixels P d'un même macropixel M. Dans cet exemple, chaque macropixel M comprend quatre pixels P adjacent adaptés à mesurer des intensités de rayonnement lumineux reçus selon respectivement quatre orientations de polarisation différentes, par exemple des polarisations linéaires selon respectivement quatre directions formant respectivement des angles de 0°, 90°, +45° et -45° par rapport à une direction de référence. Dans cet exemple les quatre pixels P sont agencés en matrice selon deux lignes et deux colonnes.

Les structures de polarisations sont par exemple des grilles métalliques constituées chacune d'une pluralité de barres métalliques parallèles régulièrement espacées, transmettant majoritairement les rayonnements selon une polarisation linéaire perpendiculaire aux barres métalliques, et absorbant les rayonnements selon les autres polarisations.

A titre de variante, le nombre de pixels P par macropixel M peut être différent de quatre. De plus, les modes de réalisation décrits ne se limitent pas à des structures de polarisation 111 linéaires. A titre de variante, chaque macropixel M peut comprendre une ou plusieurs structures de polarisation 111 linéaires et/ou une ou plusieurs structures de polarisation 111 circulaires.

A titre d'exemple, les structures de polarisation 111 des pixels P de même position dans les différents macropixels M du capteur sont adaptées à transmettre majoritairement la même orientation de polarisation.

A titre d'exemple, les structures de polarisation 111 de même orientation de polarisation dans les différents macro-pixels M du capteur sont toutes identiques, aux dispersions de fabrication près.

A titre de variante, les structures de polarisation 111 de même orientation de polarisation dans les différents macro-pixels M du capteur présentent des motifs adaptés en fonction de la position du macropixel M sur le capteur, pour tenir compte de la direction d'incidence principale des rayons lumineux reçus par le macropixel.

Dans l'exemple de la figure 1, chaque pixel P du capteur 100 comprend un filtre couleur 113 disposé au-dessus de la structure de polarisation et adapté à transmettre la lumière majoritairement dans une gamme de longueurs d'ondes déterminée. Des pixels P différents peuvent comprendre des filtres couleur 113 différents. A titre d'exemple, le capteur comprend des pixels P comprenant un filtre couleur 113 adapté à transmettre majoritairement de la lumière rouge (R), des pixels P comprenant un filtre couleur 113 adapté à transmettre majoritairement de la lumière verte (G), et des pixels P comprenant un filtre couleur 113 adapté à transmettre majoritairement de la lumière bleue (B). A titre d'exemple, les pixels P d'un même macro-pixel M comprennent des filtres couleurs 113 identiques, et les pixels P de macro-pixels M voisins comprennent des filtres couleurs différents. Les filtres couleur 113 sont par exemple en résine colorée.

A titre d'exemple, les structures de polarisation 111 de même orientation de polarisation dans les différents macro-pixels M du capteur présentent des motifs adaptés en fonction de la couleur du pixel, c'est à dire de la gamme de longueurs d'ondes transmise majoritairement par le filtre couleur 113 du pixel.

A titre d'exemple, non limitatif, pour des polariseurs linéaires du type illustré en figure 2, réalisés en aluminium avec un remplissage en oxyde de silicium, et destinés à fonctionner à des longueurs d'onde visible et/ou infrarouge, le dimensionnement des barres métalliques peut être comme suit :
- pour de la lumière bleue de longueur d'onde de l'ordre de 450 nm (et/ou pour de la lumière de longueur d'onde supérieure, par exemple de la lumière infrarouge), les barres métalliques peuvent avoir une hauteur comprise entre 50 et 100 nm, une largeur de l'ordre de 60 nm et une période de répétition de l'ordre de 180 nm ;
- pour de la lumière verte de longueur d'onde de l'ordre de 530 nm (et/ou pour de la lumière de longueur d'onde supérieure, par exemple de la lumière infrarouge), les barres métalliques peuvent avoir une hauteur comprise entre 50 et 100 nm, une largeur de l'ordre de 70 nm et une période de répétition de l'ordre de 210 nm ;
- pour de la lumière rouge de longueur d'onde de l'ordre de 610 nm (et/ou pour de la lumière de longueur d'onde supérieure, par exemple de la lumière infrarouge), les barres métalliques peuvent avoir une hauteur comprise entre 50 et 100 nm, une largeur de l'ordre de 80 nm et une période de répétition de l'ordre de 240 nm ;
- pour de la lumière infrarouge de longueur d'onde de l'ordre de 940 nm ou supérieure, les barres métalliques peuvent avoir une hauteur comprise entre 50 et 100 nm, une largeur de l'ordre de 90 nm et une période de répétition de l'ordre de 280 nm.

En pratique, pour des questions de simplification des procédés de fabrication, il est préférable que la hauteur des barres métalliques des structures de polarisation 111 soit la même dans tous les pixels P du capteur. Ainsi, des compromis peuvent être réalisés entre la complexité de réalisation des polariseurs 111 et leurs performances de filtrage de polarisation.

Dans l'exemple de la figure 1, les filtres couleurs 113 sont disposés au-dessus de la couche de planarisation 115, par exemple en contact, par leur face inférieure, avec la face supérieure de la couche 115.

Dans l'exemple de la figure 1, chaque pixel P du capteur 100 comprend en outre une microlentille 117 surmontant la structure de polarisation 111 du pixel, adaptée à focaliser la lumière incidente dans la région photosensible 103 du pixel. Dans l'exemple représenté, chaque microlentille 117 est disposée au-dessus du filtre couleur 113 du pixel et est par exemple en contact, par sa face inférieure, avec la face supérieure du filtre couleur 113.

Selon un aspect d'un mode de réalisation, chaque pixel P du capteur 100 comprend en outre une structure de diffraction 119 formée du côté de la face d'éclairement de la région photosensible 103 du pixel, c'est à dire du côté de sa face supérieure dans l'orientation de la figure 1. La structure de diffraction est disposée entre la région photosensible 103 et la structure de polarisation 111, par exemple en contact avec la face supérieure du substrat 101.

Dans l'exemple représenté, la structure de diffraction comprend des structurations, par exemple des cavités ou tranchées, formées dans le substrat 101 du côté de la face supérieure de la région photosensible 103 du pixel. Les structurations sont par exemple remplies d'un matériau d'indice de réfraction différent de celui du matériau du substrat, par exemple de l'oxyde de silicium. Les structurations ont par exemple une dimension latérale de l'ordre de λ/N, λ désignant la longueur d'onde principale de sensibilité du pixel, c'est à dire, par exemple, la longueur d'onde pour laquelle le rendement quantique du pixel est maximal, ou la longueur d'onde principale destinée à être mesurée par le pixel, et N étant l'indice de réfraction du substrat, par exemple en silicium, afin de se placer en régime de diffraction.

Dans chaque pixel P, la structure 119 permet de diffracter la lumière à l'entrée dans le matériau semiconducteur du substrat, de façon à augmenter la longueur du trajet optique des rayons dans la région photosensible 103 du pixel, et ainsi favoriser l'absorption, et par conséquent la photo-conversion, des rayons incidents par la région photosensible 103 du pixel.

A titre d'exemple, les structures de diffraction 119 des différents pixels P du capteur sont adaptées en fonction de la longueur d'onde principale destinée à être mesurée par le pixel et/ou de l'angle d'incidence principal des rayons atteignant le pixel (c'est à dire en fonction de la position du pixel dans le capteur).

Selon un aspect du mode de réalisation de la figure 1, dans chaque pixel P du capteur, la structure de diffraction 119 du pixel est adaptée à la polarisation destinée à être mesurée principalement par le pixel, appelée polarisation du pixel, de façon à favoriser l'absorption des rayonnements dans la région photosensible 103 majoritairement selon la polarisation du pixel. Autrement dit, le motif de la structure de diffraction 119 est choisi de façon à ce que l'absorption des rayonnements polarisés selon la polarisation du pixel (définie par la structure de polarisation 111) soit supérieure à l'absorption des rayonnements selon les autres polarisations.

Ainsi, dans le mode de réalisation de la figure 1, les pixels P comprenant des structures de polarisation 111 différentes comprennent des structures de diffraction 119 différentes.

La présence des structures de diffraction 119 permet, dans chaque pixel, d'améliorer la sensibilité à la polarisation du pixel, c'est à dire le rendement quantique du pixel éclairé selon la polarisation du pixel. Les structures de diffraction 119 permettent en outre d'augmenter le coefficient d'extinction ou contraste des pixels, c'est à dire, dans chaque pixel, le rapport entre le rendement quantique du pixel éclairé selon la polarisation du pixel et le rendement quantique du pixel éclairé selon la polarisation orthogonale à la polarisation du pixel.

Les structures de diffraction 119 sont par exemple fortement asymétriques pour favoriser la diffraction de la lumière selon la polarisation du pixel par rapport aux autres polarisations.

Le choix des motifs et le dimensionnement des structures de diffraction 119 peut être réalisé au moyen d'outils de simulation électromagnétiques.

La figure 3 illustre schématiquement un exemple de réalisation des structures de diffraction 119 des pixels P du macropixel M de la figure 2. Dans cet exemple, dans chaque pixel, la structure de polarisation 119 est constituée de tranchées parallèles aux barres métalliques de la structure de polarisation 111 du pixel, s'étendant verticalement dans le substrat 101 à partir de la face supérieure du substrat 101.

On notera toutefois que les structures de polarisation 111 et les structures de diffraction 119 peuvent être différentes en termes de dessin et de matériaux, et n'exploitent pas les mêmes principes physiques. En particulier, le rôle des structures de polarisation 111 est de transmettre majoritairement la polarisation principale du pixel et d'absorber ou réfléchir les autres polarisations, tandis que le rôle de la structure de diffraction 119 est de diffracter plus fortement la polarisation principale du pixel par rapport aux autres polarisations.

Il en résulte que les structures 111 et 119 d'un même pixel P n'ont pas nécessairement le même axe principal et leurs orientations respectives peuvent dépendre de paramètres comme la longueur d'onde, le taux d'ouverture et/ou la taille du pixel.

Ainsi, à titre de variante, non représentée, chaque structure de diffraction 119 peut être constituée de tranchées orthogonales aux barres métalliques de la structure de polarisation 111 du pixel.

On notera en outre que les dimensions latérales et la période de répétition des tranchées des structures de diffraction 119 ne sont pas nécessairement identiques aux dimensions latérales et à la période de répétition des barres métalliques des structures de polarisation 111. De plus, la profondeur des tranchées des structures de diffraction peut être différente de la hauteur des barres métalliques des structures de polarisation.

Dans l'exemple considéré ci-dessus dans lequel chaque macropixel M comprend plusieurs pixels P adaptés à mesurer respectivement des polarisations linéaires différentes, les structures de polarisation 111 des différents pixels ont par exemple le même motif, tourné d'un angle θ égal à l'angle formé entre la direction de polarisation à mesurer et une direction de référence. De façon similaire, les structures de diffraction 119 des différents pixels ont par exemple le même motif, également tourné de l'angle θ.

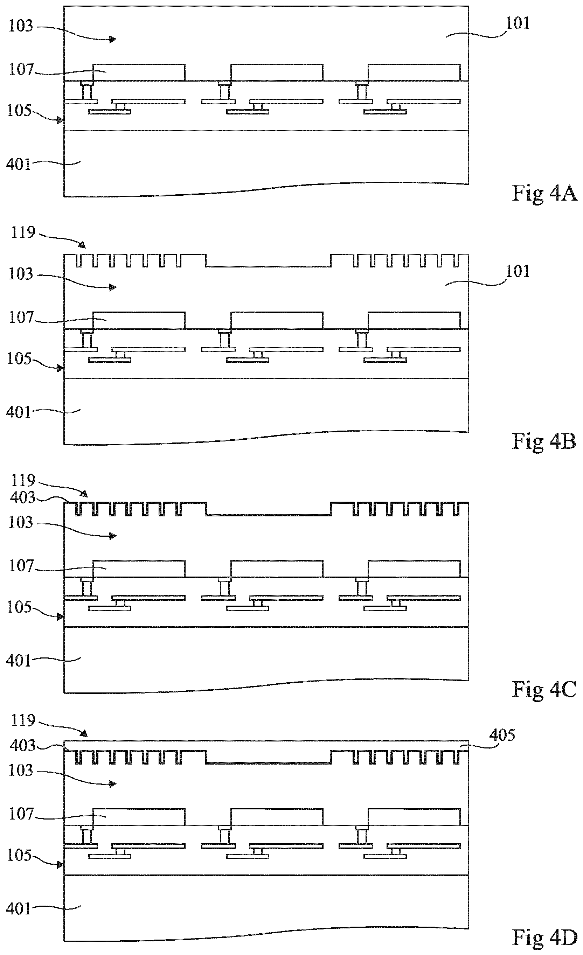

Les figures 4A à 4I sont des vues en coupe illustrant des étapes successives d'un exemple d'un procédé de fabrication du capteur 100 de la figure 1.

La figure 4A illustre une structure intermédiaire à l'issue d'une étape de formation des photodétecteurs 107 dans le substrat 101, du côté de la face inférieure du substrat, puis d'une étape de formation de l'empilement d'interconnexion 105 sur la face inférieure du substrat. Des transistors de contrôle et/ou de lecture, non détaillés sur les figures, peuvent en outre être formés dans et sur la face inférieure du substrat, avant la réalisation de l'empilement d'interconnexion 105.

Dans l'exemple de la figure 4A, après la formation des photodétecteurs 107 et de l'empilement d'interconnexion 105, le substrat 101 est aminci par sa face arrière, c'est à dire sa face supérieure dans l'orientation de la figure 4A.

Avant l'étape d'amincissement, un substrat 401, servant de poignée de support, est fixé, par sa face supérieure, à la face inférieure de l'empilement d'interconnexion 105.

On notera que sur les vues en coupe des figures 4A à 4I, les murs 109 d'isolation latérale des pixels n'ont pas été représentés. Les murs 109 peuvent être formés du côté de la face avant du substrat 101, avant la formation de l'empilement d'interconnexion 105, ou par la face arrière du substrat 101, après l'étape d'amincissement du substrat.

La figure 4B illustre la structure obtenue à l'issue d'une étape de gravure de tranchées localisées dans le substrat 101, du côté de la face arrière du substrat 101, pour former les structures de diffraction 119 des pixels. Les tranchées gravées à cette étape ont par exemple une profondeur comprise entre 50 et 500 nm.

La figure 4C illustre la structure obtenue à l'issue d'une étape de dépôt d'une couche de passivation 403, par exemple en un matériau diélectrique, sur et en contact avec la face supérieure du substrat 102 à l'issue de l'étape de gravure de la figure 4B. La couche 403 est par exemple déposée de façon continue et avec une épaisseur sensiblement uniforme sur toute la surface supérieure de la structure de la figure 4B. La couche 403 est par exemple déposée par une méthode de dépôt conforme. L'épaisseur de la couche 403 est par exemple relativement faible de façon que la couche 403 ne comble pas entièrement les tranchées. A titre d'exemple, l'épaisseur de la couche 403 est comprise entre 1 et 20 nm, par exemple entre 1 et 10 nm. La couche 403 est par exemple en un oxyde chargé électriquement, par exemple de l'alumine (Al₂O₃) ou de l'oxyde d'hafnium (HfO₂).

La figure 4D illustre la structure obtenue à l'issue d'une étape de dépôt d'une couche de planarisation 405 remplissant les tranchées des structures de diffraction 119 et recouvrant les structures de diffraction 119. Dans cet exemple, la couche 405 présente une face supérieure sensiblement plane s'étendant sur toute la surface du capteur. La couche 405 est par exemple en oxyde de silicium ou en nitrure de silicium.

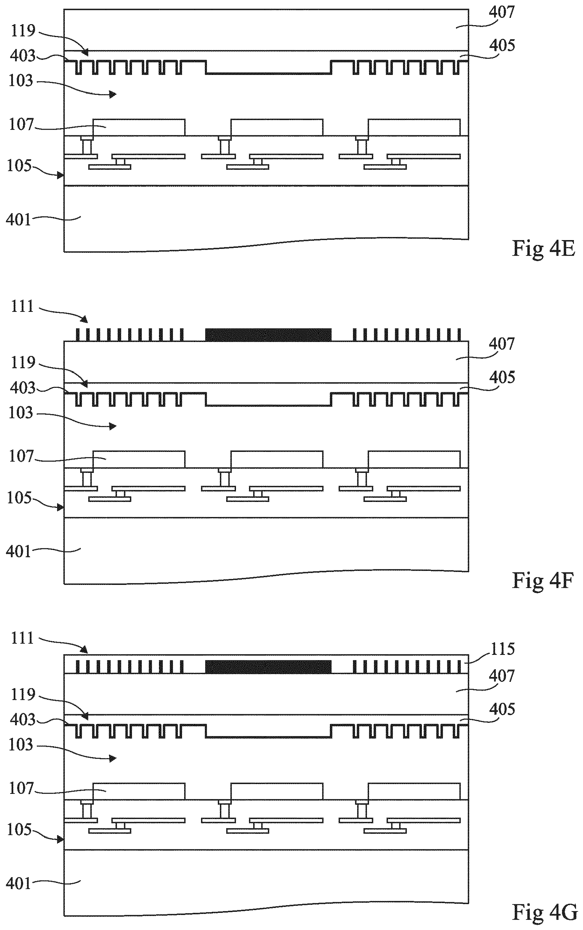

La figure 4E illustre la structure obtenue à l'issue d'une étape de dépôt d'une couche transparente 407 optionnelle ayant fonction d'espaceur optique, sur la face supérieure de la couche 405. La couche 407 est par exemple en un matériau transparent d'indice de réfraction relativement faible, par exemple inférieur à 2.

La figure 4F illustre la structure obtenue à l'issue d'une étape de formation des structures de polarisation 111 du capteur, par exemple en métal, sur la face supérieure de la couche 407. A titre d'exemple, une couche métallique, par exemple en aluminium, est d'abord déposée de façon continue et avec une épaisseur uniforme sur toute la surface supérieure de la structure, puis retirée de façon localisée, par exemple par photolithographie et gravure, pour définir les polariseurs 111.

La figure 4G illustre la structure obtenue à l'issue d'une étape de dépôt de la couche transparente de planarisation 115 remplissant les ouvertures des polariseurs 111 et recouvrant les polariseurs 111.

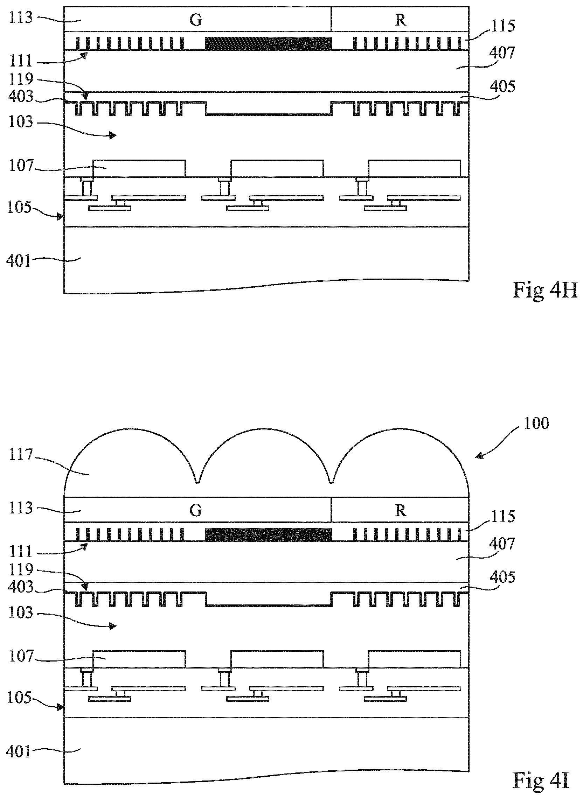

La figure 4H illustre la structure obtenue à l'issue d'une étape de formation des filtres colorés 113, par exemple en résine, sur la face supérieure de la structure de la figure 4G.

La figure 4I illustre la structure obtenue à l'issue d'une étape de formation de microlentilles 117 sur la face supérieure de la structure de la figure 4H.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

En particulier, bien que l'on ait décrit ci-dessus des exemples de réalisation de capteurs à éclairement par la face arrière (BSI), les modes de réalisation décrits peuvent être adaptés à des capteurs à éclairement par la face avant (FSI - de l'anglais « Front Side Illumination »). Dans ce cas, la région photosensible de chaque pixel est éclairée à travers l'empilement d'interconnexion 105. Les structures de diffraction 119 sont alors formées du côté de la face avant (face inférieure dans l'orientation de la figure 1) du substrat, avant la formation de l'empilement d'interconnexion 105. A titre d'exemple, les structures de diffraction peuvent alors être des tranchées similaires à ce qui a été décrit ci-dessus, mais gravées du côté de la face avant du substrat. A titre de variante, les structures de diffractions peuvent être constituées par des plots ou barreaux de silicium polycristallin formés sur la face avant du substrat. A titre d'exemple, les structures de diffraction peuvent être formées dans le même niveau de silicium polycristallin que celui utilisé pour former des grilles conductrices de transistors MOS des pixels du capteur. Ceci présente l'avantage de ne pas nécessiter une gravure du substrat 101 pour former les structures de diffraction 119.

Par ailleurs, dans le cas d'un capteur à éclairement par la face avant, les structures de polarisation 111 peuvent être formées dans un ou plusieurs niveaux métalliques de l'empilement d'interconnexion 105. Là encore, ceci permet de ne pas introduire d'étape supplémentaire pour la fabrication des structures de polarisation 111.

En outre, les modes de réalisation décrits ne se limitent pas aux exemples présentés ci-dessus de réalisation de structures de polarisation 111 constituées de motifs métalliques, opaques, entourés latéralement d'un matériau diélectrique, transparent. A titre de variante, les structures de polarisation 111 peuvent être réalisées à base de matériaux transparents ou semi-transparents présentant un contraste d'indice, de manière à améliorer la transmission des polariseurs. Par exemple, pour des structures de polarisation destinées à fonctionner dans le proche infrarouge, par exemple à une longueur d'onde de l'ordre de 940 nm, on pourra utiliser des motifs en silicium, par exemple en silicium amorphe, entourés d'un matériau diélectrique de plus faible indice de réfraction, par exemple de l'oxyde de silicium. Pour des pixels destinés à mesurer des rayonnements visibles, on pourra utiliser des motifs en nitrure de silicium ou en oxyde de titane, entourés d'un matériau diélectrique de plus faible indice de réfraction, par exemple de l'oxyde de silicium.

Par ailleurs, on a décrit ci-dessus des exemples de structures polarisantes 111 constituées de barres parallèles d'orientation choisie en fonction de la direction de polarisation linéaire à transmettre. Il s'agit de structures sub-longueur d'onde que l'on peut qualifier de métasurfaces à une dimension (1D) car structurées selon un axe unique. A titre de variante, les structures de polarisation 111 peuvent être réalisées à base de métasufaces à deux dimensions (2D), constituées de piliers ou plots agencés sous forme d'un réseau à deux dimensions. Pour obtenir l'effet polarisant recherché, on choisira des piliers présentant, en vue de dessus, une forme allongée, par exemple en rectangle ou en ellipse, selon une direction choisie en fonction de la direction de polarisation linéaire à transmettre.

Par ailleurs, on notera que, dans les exemples décrits ci-dessus, les structures de polarisation 111 ont une fonction de filtrage de polarisation. En d'autres termes, la polarisation que l'on souhaite mesurer est transmise par la structure 111, tandis que la polarisation orthogonale est absorbée ou réfléchie. Ceci conduit à une perte de flux lumineux de l'ordre de 50% dans le cas d'une lumière dépolarisée. A titre de variante, les structures de polarisation 111 peuvent être des structures de tri, adaptées à dévier la lumière différemment en fonction de sa polarisation. On pourra notamment prévoir des structures 111 adaptées à dévier la lumière vers respectivement deux régions photosensibles 103 voisines pour deux polarisations orthogonales. A titre d'exemple, dans le cas d'un macropixel M du type décrit en relation avec la figure 2, les structures de polarisation 111 des quatre pixels P du macropixel peuvent être remplacées par une structure 111 unique s'étendant sur toute la surface du macropixel, adaptée à dévier la lumière vers respectivement les régions photosensibles 103 des quatre pixels P pour les quatre polarisations (0°, 90°, +45° et - 45°) que l'on cherche à mesurer.

De telles structures de tri de polarisation, aussi appelées routeurs de polarisation, peuvent être réalisées à base de métasurfaces à deux dimensions (2D) ou à trois dimensions (3D). La forme et le dimensionnement des motifs des métasurfaces peuvent être déterminés au moyen d'outils de simulation électromagnétique, par exemple en utilisant des méthodes de conception inverse, par exemple du type décrit dans l'article intitulé « Multifunctional volumetric meta-optics for color and polarization image sensors » de Philip Camayd-Munoz et al. (Vol. 7, No. 4 / April 2020 / Optica) ou dans l'article intitulé « Empowering Metasurfaces with Inverse Design: Principles and Applications » de Zhaoyi Li et al. (https://doi.org/10.1021/acsphotonics.1c01850).

On notera en outre que, dans un capteur à éclairement par la face arrière du type décrit en relation avec la figure 1, en fonction de l'épaisseur du substrat 101 et de la longueur d'onde destinée à être mesurée par les pixels, une partie du rayonnement lumineux incident peut traverser toute l'épaisseur du substrat et se réfléchir sur des pistes métalliques de l'empilement d'interconnexion 105, avant d'être absorbé dans la région photosensible 103 des pixels.

La réflexion sur les pistes métalliques de l'empilement d'interconnexion peut conduire à polariser au moins partiellement la lumière selon une direction dépendant de l'orientation desdites pistes métalliques. De façon préférentielle, pour chaque pixel P du capteur, les pistes métalliques de l'empilement d'interconnexion 105 situées en vis à vis du pixel sont orientées selon une direction choisie en fonction de la polarisation du pixel, par exemple de façon à favoriser la polarisation de la lumière réfléchie selon l'orientation de polarisation destinée à être mesurée par le pixel. Ainsi, de façon préférentielle, les pistes métalliques de l'empilement d'interconnexion 105 situées en vis à vis de pixels destinés à mesurer des polarisations différentes, présentent des orientations différentes.

Par ailleurs, les modes de réalisation décrits ne se limitent pas aux exemples d'application décrits ci-dessus à des capteurs visibles ou proche infrarouge. D'autres gammes de longueurs d'ondes peuvent tirer profit de pixels polarisants. Par exemple, les modes de réalisation décrits peuvent être adaptés à des capteurs infrarouges destinés à mesurer des rayonnements de longueur d'onde comprise entre 1 et 2 µm, par exemple à base d'InGaAs ou de germanium.

Enfin, la mise en oeuvre pratique des modes de réalisation et variantes décrits est à la portée de la personne du métier à partir des indications fonctionnelles données ci-dessus. En particulier, la personne du métier saura, à partir des indications de la présente description, concevoir, dimensionner et réaliser les structures de polarisation et les structures de diffraction des pixels du capteur, de façon que ces structures coopèrent pour obtenir l'effet recherché d'amélioration du compromis entre la sensibilité et le coefficient d'extinction de polarisation des pixels.

## Revendications

1. Capteur d'images polarimétrique (100) formé dans et sur un substrat semiconducteur (101), le capteur comprenant une pluralité de pixels (P) comprenant chacun :
- une région photosensible (103) formée dans le substrat semiconducteur (101) ;
- une structure de diffraction (119) formée du côté d'une face d'éclairement de la région photosensible (103) ; et
- une structure de polarisation (111) formée du côté de la structure de diffraction (119) opposé à la région photosensible (103).

2. Capteur (100) selon la revendication 1, dans lequel ladite pluralité de pixels (P) comprend au moins des premier et deuxième pixels adaptés à mesurer des rayonnements selon respectivement des première et deuxième polarisations distinctes, dans lequel :
la structure de polarisation (111) du premier pixel (P) est adaptée à transmettre majoritairement des rayonnements selon la première polarisation et la structure de polarisation (111) du deuxième pixel (P) est adaptée à transmettre majoritairement des rayonnements selon la deuxième polarisation ; et
la structure de diffraction (119) du premier pixel (P) est adaptée à favoriser l'absorption, dans la région photosensible (103) du pixel, des rayonnements selon la première polarisation par rapport aux rayonnements selon la deuxième polarisation, et la structure de diffraction (119) du deuxième pixel (P) est adaptée à favoriser l'absorption, dans la région photosensible (103) du pixel, des rayonnements selon la deuxième polarisation par rapport aux rayonnements selon la première polarisation.

3. Capteur (100) selon la revendication 1 ou 2, dans lequel, dans chaque pixel (P), la structure de polarisation (111) du pixel comprend une pluralité de barres parallèles.

4. Capteur (100) selon la revendication 3, dans lequel lesdites barres parallèles sont métalliques.

5. Capteur (100) selon l'une quelconque des revendications 1 à 4, dans lequel, dans chaque pixel (P), la structure de diffraction (119) du pixel comprend une pluralité de cavités ou tranchées s'étendant verticalement dans le substrat du côté de la face d'éclairement de la région photosensible (103).

6. Capteur (100) selon la revendication 5, dans lequel lesdites cavités ou tranchées s'étendent sur une profondeur comprise entre 50 et 500 nm.

7. Capteur (100) selon l'une quelconque des revendications 1 à 6, dans lequel ladite pluralité de pixels (P) comprend différents pixels adaptés à mesurer des rayonnements dans des gammes de longueurs d'ondes différentes, et dans lequel, dans chaque pixel, la structure de polarisation (111) et/ou la structure de diffraction (119) sont adaptées en fonction de la gamme de longueurs d'onde destinée à être mesurée par le pixel.

8. Capteur (100) selon l'une quelconque des revendications 1 à 7, dans lequel, dans chaque pixel (P), la structure de polarisation (111) et/ou la structure de diffraction (119) sont adaptées en fonction de l'angle d'incidence des rayonnements reçus par le pixel.

9. Capteur (100) selon l'une quelconque des revendications 1 à 8, comprenant un empilement d'interconnexion recouvrant une face du substrat (101) opposée aux structures de diffraction (119) et aux structures de polarisation (111).

10. Capteur (100) selon l'une quelconque des revendications 1 à 9, dans lequel, les structures de polarisation (111) sont des filtres polariseurs.

11. Capteur (100) selon l'une quelconque des revendications 1 à 9, dans lequel les structures de polarisation (111) sont des routeurs de polarisation.
